(19) Europäisches Patentamt
European Patent Office
Office européen des brevets

(11) **EP 3 462 186 A1**

(12) **EUROPÄISCHE PATENTANMELDUNG**

(43) Veröffentlichungstag:
**03.04.2019 Patentblatt 2019/14**

(51) Int Cl.:
**G01R 19/00** *(2006.01)*    **F03D 17/00** *(2016.01)*

(21) Anmeldenummer: **18196879.3**

(22) Anmeldetag: **26.09.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **28.09.2017   DE 102017009150**

(71) Anmelder: **Senvion GmbH**
**22297 Hamburg (DE)**

(72) Erfinder:
• **Letas, Heinz-Hermann**
**24796 Bovenau (DE)**
• **Diering, Markus**
**24879 Neuberend (DE)**

(74) Vertreter: **Glawe, Delfs, Moll**
**Partnerschaft mbB von**
**Patent- und Rechtsanwälten**
**Postfach 13 03 91**
**20103 Hamburg (DE)**

(54) **WINDENERGIEANLAGE MIT DOPPELTER SPANNUNGSMESSUNG UND NACHRÜSTSATZ**

(57)    Windenergieanlage umfassend einen Windrotor (11), Generator (12) sowie einen Umrichter (13) zur Erzeugung elektrischer Leistung, die über eine mehrphasige Anschlussleitung (16) abgegeben wird, und eine Steuerung (2), die den Betrieb der Windenergieanlage kontrolliert und ein Netzüberwachungsmodul (21) aufweist. Messwandler (30) sind zur Spannungsmessung vorgesehen, die ein Signal für gemessene Strangspannungen (US1, US2, US3) abgeben. In deren Ausgangsleitung (31, 32, 33) sind Zusatzwandler (40) eingeschleift, deren interne Verschaltung zur Bildung von verketteten Spannungen (US12, US23, US31) ausgebildet ist, so dass ein Ausgangssignal der Zusatzwandler (40) ein Maß für die verketteten Spannungen (US12, US23, US31) in der Anschlussleitung (16) ist und an die Stelle der Strangspannungen tritt. So kann bei an sich unveränderter, auf die Verarbeitung von Strangspannungen ausgelegter Windenergieanlage auf einfache Weise eine wenig aufwendige und robuste Bestimmung der verketteten Spannungen erfolgen, ohne dass in die auf die Messung von Strangspannungen ausgelegte Windenergieanlage eingegriffen zu werden braucht. Die Erfindung bezieht sich ferner auf einen entsprechenden Nachrüstsatz und Verfahren.

Fig. 1

EP 3 462 186 A1

**Beschreibung**

Die Erfindung betrifft eine Windenergieanlage umfassend einen Windrotor, einen davon angetriebenen Generator sowie einen Umrichter zur Erzeugung elektrischer Leistung, die über eine mehrphasige Anschlussleitung an ein Netz abgegeben wird. Es sind Messwandler zur Spannungsmessung insbesondere netzseitig vorgesehen, die ein Signal für gemessene Strangspannungen über eine Ausgangsleitung an ein Netzüberwachungsmodul einer Steuerung abgeben.

Windenergieanlagen sind in zunehmendem Maße an Spannungsnetze angeschlossen, in denen es bei der Frage der Einhaltung von Netzparametern auf verkettete Spannungen ankommt. Hierzu zählen insbesondere Mittelspannungsnetze. Hintergrund ist, dass eine Betrachtung der verketteten Spannungen im Rahmen der Netzüberwachung sich als robuster erwiesen hat. Dies gilt insbesondere für den vergleichsweise häufigen Fall von Erdungsfehlern, vor allem einen sogenannten einpoligen Erdschluss. Letzterer hat die Eigenart, dass er bei isoliertem Netz im Grundsatz einen Weiterbetrieb ermöglicht, allerdings mit einem in Bezug auf sein Potenzial verschobenen Sternpunkt. Im Hinblick auf die Robustheit der Netze ist es in zunehmendem Umfang nicht mehr gewünscht, dass Windenergieanlagen in einem solchen Fall abschalten.

Hierbei stellt sich jedoch die Problematik, dass herkömmlicherweise Windenergieanlagen Strangspannungen messen. In einem solchen Szenario mit einem einpoligen Erdschluss ist jedoch mindestens eine Strangspannung außerhalb des zulässigen Bereichs, sodass die Windenergieanlage dann zwangsläufig abschaltet.

Um bei Bedarf betroffenen Windenergieanlagen dennoch einen Weiterbetrieb in einem solchen Szenario zu ermöglichen, ist es erforderlich, dass andere Messwandler verwendet werden. Benötigt werden solche, welche die verketteten Spannungen erfassen. Der einfache Ersatz von herkömmlichen Messwandlern zur Messung von Strangspannungen durch solche zur Messung von verketteten Spannungen ist jedoch nicht trivial, da dazu insbesondere auch die Verarbeitung der Messwerte innerhalb der Steuerung der Windenergieanlage, und zwar insbesondere deren Netzüberwachungsmodul, verändert werden müsste. So ist dies wegen des hohen damit verbundenen Aufwands innerhalb einer laufenden Serie kaum praktikabel.

Der Erfindung liegt die Aufgabe zugrunde, mit geringem Aufwand herkömmliche Windenergieanlagen mit herkömmlichen Messwandlern zur Messung von Strangspannungen so zu ertüchtigen, dass sie in dem skizzierten Szenario weiterlaufen können, ohne dass hierzu die zur Spannungsmessung verwendeten Messwandler ausgewechselt werden müssen. Dies ist aufwendig und innerhalb einer laufenden Serie nur schwer möglich. Alternativ kann auch vorgesehen sein, dass gemessene Werte für Strangspannungen innerhalb der Software der Steuerung umgerechnet werden auf verkettete Spannungen. Allerdings verlangt dies ebenfalls eine Veränderung, nämlich in dem Fall der Steuerungssoftware. Auch das ist innerhalb einer laufenden Serie mitunter nicht unproblematisch.

Gesucht wird eine einfachere Lösung, die sich insbesondere auch zur Nachrüstung von bestehenden herkömmlichen Windenergieanlagen eignet.

Die erfindungsgemäße Lösung liegt in den Merkmalen der unabhängigen Ansprüche. Vorteilhafte Weiterbildungen sind Gegenstand der abhängigen Ansprüche.

Bei einer Windenergieanlage umfassend einen Windrotor, einen davon angetriebenen Generator sowie einen Umrichter zur Erzeugung elektrischer Leistung, die über eine mehrphasige Anschlussleitung an ein Netz abgegeben wird, und eine Steuerung, die den Betrieb der Windenergieanlage kontrolliert und ein Netzüberwachungsmodul aufweist, wobei Messwandler zur Spannungsmessung vorgesehen sind, die ein Signal für gemessene Strangspannungen über eine Ausgangsleitung abgeben, ist erfindungsgemäß vorgesehen, dass den Messwandlern Zusatzwandler nachgeschaltet sind, die in die Ausgangsleitung der Messwandler eingeschleift sind, wobei die Zusatzwandler eine interne Verschaltung aufweisen, welche ausgebildet ist zur Bildung von verketteten Spannungen, und ein Ausgangssignal der Zusatzwandler ein Maß für die verketteten Spannungen in der Anschlussleitung ist und an die Stelle der Strangspannungen tritt.

Der Kern der Erfindung liegt in dem Gedanken, zusätzliche Messwandler vorzusehen (vorliegend als Zusatzwandler bezeichnet), die den vorhandenen Messwandlern nachgeschaltet werden. Damit greifen die Zusatzwandler in das Ausgangssignal der vorhandenen Messwandler ein und verändern dieses. Erfindungsgemäß sind die Zusatzwandler so geschaltet, dass sie anhand der von den vorhandenen Messwandlern bestimmten Strangspannungen eine Erfassung der verketteten Spannungen bewirken. Diese geben sie dann als (modifiziertes) Ausgangssignal an die Steuerung aus. Damit erhält die Steuerung Messwerte für die verketteten Spannungen. Weitere Änderungen an der Steuerung sind somit nicht erforderlich. Weiter bleiben die vorhandenen Messwandler erhalten, sodass im Kern keine Änderungen an der Windenergieanlage an sich erforderlich werden.

Durch die erfindungsgemäß angeordneten Zusatzwandler erfolgt eine echte Messung der verketteten Spannungen. Es handelt sich also nicht um eine Umrechnung, sodass die für Umrechnungen typischen Probleme (wie Zeitverzögerung, Nullpunktempfindlichkeit etc.) vermieden werden können. Besonders bevorzugt ist es, wenn hierbei die Zusatzwandler so ausgebildet sind, dass sie eine Verkettung der Spannungen bewirken. Somit kann auf elegante Weise, nämlich im Grunde allein durch eine intelligent gewählte Verschaltung der Zusatzwandler, die gewünschte Erfassung von verketteten Spannungen erreicht werden.

Die Erfindung erreicht so auf verblüffend einfache Weise eine wenig aufwendige und dennoch sehr robuste Bestimmung der verketteten Spannungen, ohne dass in das Grundkonzept der auf die Messung von Strangspannungen ausgelegten jeweiligen Windenergieanlagen eingegriffen zu werden braucht. Die Windenergieanlage an sich bleibt im Grunde unverändert.

Die Erfindung ist dadurch sehr flexibel einsetzbar. Sie eignet sich insbesondere auch zur Nachrüstung von herkömmlichen Windenergieanlagen. Dies ist im Stand der Technik ohne Beispiel.

Zweckmäßigerweise weisen die Zusatzwandler einen Verstärkungsfaktor von kleiner als Eins auf. Durch die mit den Zusatzwandlern bewirkte Erfassung der verketteten Spannungen erfolgt eine Steigerung des gemessenen Spannungswerts. Um dennoch die Eingänge der Steuerung, an welche die gemessenen Spannungssignale angelegt sind, nicht zu übersteuern, wird mit einem Verstärkungsfaktor von weniger als eins eine gewünschte Abschwächung erzielt.

Vorzugsweise ist hierbei der Verstärkungsfaktor so gewählt, dass ein Ausgangspegel der Zusatzwandler übereinstimmt mit einem Ausgangspegel der Messwandler. Somit hat aus Sicht der Steuerung, in welche die Ausgangssignale der Messwandler bzw. Zusatzwandler angelegt sind, überhaupt keine Pegelveränderung stattgefunden. Der einzige Unterschied liegt darin, dass die Signale nunmehr für verkettete Spannungen stehen, und nicht mehr für Strangspannungen. Dies sichert einen ungestörten Weiterbetrieb der vorhandenen Steuerungen mit ihren Netzschutzmodulen. Bewährt hat es sich, wenn der Verstärkungsfaktor im Bereich zwischen 1:2 und 2:3 liegt. Besonders bevorzugt ist ein Wert von 0,5735. Dies entspricht dem Kehrwert der Quadratwurzel aus 3 $\left(1/\sqrt{3}\right)$, womit eine ideale Pegelanpassung erreicht wird.

Vorzugsweise sind die Zusatzwandler potenzialfrei ausgeführt, insbesondere erdfrei. Damit wird eine größtmögliche Robustheit gegenüber Potenzialverschiebungen erreicht, wie sie insbesondere bei Erdschlüssen oder anderen Netzfehlern im Übertragungsnetz typisch sind.

Im Grunde genügt es, zur Bestimmung der verketteten Spannung die erfindungsgemäßen Zusatzwandler den Messwandlern nachzuschalten. Allerdings führen die Zusatzwandler zu einer Phasenverschiebung, wodurch sich ungünstige Folgen im Hinblick auf eine Leistungsberechnung durch die Steuerung ergeben. Die Erfindung sieht vor, dass zweckmäßigerweise ferner Messwandlern für Strom eine gesonderte Phasenschwenkeinheit nachgeschaltet ist. Mittels dieser gesonderten Phasenschwenkeinheit kann der Messwert für den Strom ebenfalls bezüglich seiner Phase verschoben werden, wodurch die Relation mit den durch die Zusatzwandler bestimmten verketteten, phasenverschobenen Spannungssignalen wieder stimmt. Dazu ist vorzugsweise die Phasenschwenkeinheit so ausgebildet, dass die von ihr bewirkte Verschwenkung der Phasenverschiebung der Spannung durch die Zusatzwandler entspricht. Somit stimmen anhand der Messwerte für Spannung und Strom ermittelte Wirk- und Blindleistungen sowie aus den jeweiligen Messsignalen ermittelte Phasenverschiebung zwischen Strom und Spannung wieder mit den ursprünglichen Werten überein. Dies ist insbesondere für einen uneingeschränkten Weiterbetrieb einer ansonsten unveränderten Steuerung der Windenergieanlage wichtig.

Mit Vorteil ist die Phasenschwenkeinheit als Strom-Zusatzwandler ausgeführt. Es ergibt sich somit ein gleichartiger Aufbau mittels nachgeschalteter Zusatzwandler wie bei der Erfassung der Spannung. Dies ermöglicht einen rationellen Einsatz.

Zweckmäßigerweise sind die Strom-Zusatzwandler ferner so ausgeführt, dass sie einen solchen Verstärkungsfaktor aufweisen, der demjenigen der Zusatzwandler für die Spannung entspricht. Damit ist auch ein Gleichlauf der Pegel der von den Zusatzwandlern ausgegebenen Messsignale für Strom einerseits und Spannung andererseits erreicht.

Vorzugsweise sind die Zusatzwandler Nullsystem-blockend ausgeführt. Bei herkömmlichen Windenergieanlagen mit Messwandlern zur Erfassung der Strangspannungen konnte es dazu kommen, dass eine eventuell zusätzlich zur Mitsystem-Spannung und Gegensystem-Spannung vorhandene Nullsystem-Spannung mit erfasst wurde und in die weitere Verarbeitung einbezogen wurde. Dies konnte zu unerwünschten Reaktionen der Steuerung führen. Indem die Zusatzwandler blockend für das Nullsystem ausgeführt sind, wird erreicht, dass das Nullsystem herausfällt und somit nicht mehr zu unerwünschten Reaktionen in der Steuerung führen kann. Entsprechendes gilt für das Nullsystem beim Strom. Es ergibt sich somit eine qualitative Verbesserung.

Mit Vorteil sind die Zusatzwandler als zwischenschaltbare, modular einsetzbare Baueinheit ausgeführt. Damit können sie bei Bedarf optional in herkömmliche Windenergieanlagen eingesetzt werden. Bauliche Veränderungen an den Windenergieanlagen selbst sind nicht oder wenn nur in minimalem Umfang erforderlich. Dies erlaubt eine breite Einsetzbarkeit, über die gegebenenfalls auch vor Ort noch je nach Gegebenheiten entschieden werden kann.

Die Erfindung eignet sich insbesondere zur Nachrüstung von herkömmlichen Windenergieanlagen. Dazu ist vorzugsweise ein entsprechender Nachrüstsatz vorgesehen. Der Nachrüstsatz umfasst Zusatzwandler, die den Messwandlern nachgeschaltet und in die Ausgangsleitung der Messwandler eingeschleift sind. Zur näheren Erläuterung wird auf vorstehende Beschreibung verwiesen.

Die Erfindung erstreckt sich ferner auf ein entsprechendes Verfahren zur Spannungsmessung an einer mehrphasigen Anschlussleitung einer Windenergieanlage, und zwar insbesondere netzseitig eines Anlagentransformators der Windenergieanlage. Zur näheren Erläuterung wird auf vorstehende Beschreibung verwiesen.

Die Erfindung wird nachfolgend unter Bezugnahme auf die beigefügte Zeichnung anhand einer bevorzugten Ausführungsform beispielhaft erläutert. Es zeigen:

Fig. 1    eine schematische Darstellung eines Leistungsstrangs einer Windenergieanlage gemäß einem Ausführungsbeispiel der Erfindung;

Fig. 2    eine schematische Darstellung der Anschaltung von Zusatzwandlern zur Erfassung von verketteten Spannungen;

Fig. 3    Zeigerdiagramme darstellend die Phasenlage von Strangspannungen und verketteten Spannungen;

Fig. 4    eine schematische Darstellung der Anschaltung von weiteren Zusatzwandlern für Strom; und

Fig. 5    Zeigerdiagramme darstellend eine Phasenverschwenkung durch die Strom-Zusatzwandler.

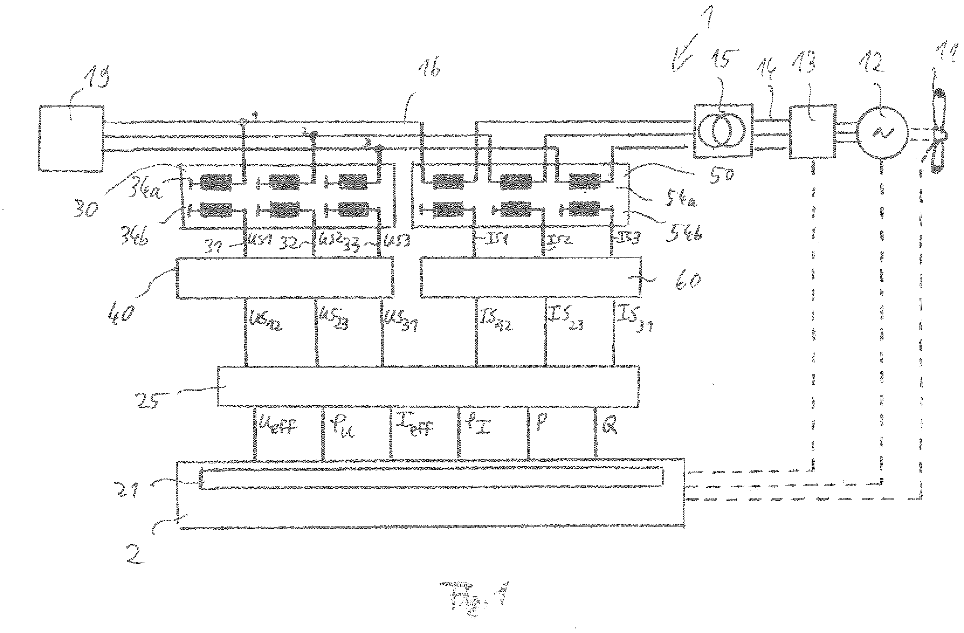

Ein Ausführungsbeispiel für eine Windenergieanlage gemäß der Erfindung ist schematisch in Figur 1 dargestellt. Die in ihrer Gesamtheit mit der Bezugsziffer 1 bezeichnete Windenergieanlage umfasst einen Windrotor 11 zum Antrieb eines Generators 12, der mit einem Umrichter 13 verbunden ist zur Erzeugung elektrischer Leistung. Die Leistung wird über eine Drehstrom-Leitung 14 mit drei Phasen und einen Anlagentransformator 15 übertragen und auf ein Mittelspannungsniveau hochgesetzt. Schließlich wird die Leistung auf Mittelspannungsniveau über eine Anschlussleitung 16 mit ebenfalls drei Phasen an eine Übertragungsleitung oder, in dem Fall wenn die Windenergieanlage 1 in einem Windpark angeordnet ist, an ein parkinternes Netz 19 übertragen.

Der Betrieb der Windenergieanlage wird kontrolliert von einer Betriebssteuerung 2, die ein Netzschutzmodul 21 umfasst. Die Betriebssteuerung 2 ist über Signalleitungen (in Figur 1 gestrichelt dargestellt) mit den wesentlichen Komponenten der Windenergieanlage 1 verbunden.

Das Netzschutzmodul 21 ist dazu ausgebildet, die Einhaltung wesentlicher Netzparameter zu überwachen. Zu den wesentlichen Netzparametern gehören insbesondere auch die Netzspannung, genauer gesagt die Spannung in den einzelnen Phasen der Anschlussleitung 16.

Zur Erfassung der Spannung in der Anschlussleitung 16 ist ein Messwandler 30 zur Spannungsmessung vorgesehen. Es handelt sich hierbei um einen handelsüblichen Messwandler, der zur Messung von Strangspannungen in den einzelnen Phasen einer Drehstromleitung ausgebildet ist. Dazu umfasst der Messwandler 30 für jede Phase einen Übertrager mit einer Primärspule 34a und eine Sekundärspule 34b. Als Ausgangssignal wird für jede Phase ein Messsignal 31, 32 und 33 ausgegeben, die in Figur 1 bezeichnet sind als US1, US2 und US3 als Werte für die einzelnen Strangspannungen in den drei Phasen der Drehstromleitung 16.

Dem handelsüblichen Messwandler für Strangspannungen 30 nachgeschaltet ist ein Zusatzwandler 40. Er ist in die Ausgangsleitung des Messwandlers 30 eingeschleift, sodass die Ausgangssignale 31, 32 und 33 des Messwandlers 30 als Eingangssignale an den Zusatzwandler 40 angelegt sind. Der Zusatzwandler weist eine besondere innere Verschaltung auf, die nachfolgend noch näher erläutert werden wird. Sie ist dazu ausgebildet, eine Verkettung der angelegten Eingangsspannungen zu bewirken und so ein Maß für verkettete Spannungen $US_{12}$, $US_{23}$ und $US_{31}$ als Ausgangssignal auszugeben. Diese Ausgangssignale für die verketteten Spannungen sind angelegt an Spannungssignaleingänge eines Messmoduls 25 zur Bestimmung von Netzparametern, wie Effektivwert, Phasenlage etc.

Ferner vorgesehen ist ein Messwandler 50 für Strom. Er ist handelsüblich ausgeführt und weist für jede der Phasen einen Übertrager mit einer Primärspule 54a und einer Sekundärspule 54b auf. Als Ausgangssignale 51, 52 und 53 des Messwandlers 50 werden Signale für die Ströme IS1, IS2 und IS3 in den drei Strängen der Anschlussleitung 16 ausgegeben. Diese Ausgangssignale sind angelegt an einen Eingang eines Strom-Zusatzwandlers 60. Dessen Ausgangssignale sind wiederum in ähnlicher Weise wie die Ausgangssignale des Zusatzwandlers 60 angeschlossen an Eingänge des Messmoduls 25.

Bei den Messwandlern 30, 50 handelt es sich um übliche Mittelspannungs-Messwandler, die auch als sogenannte "Instrument Transformer" bekannt sind und auf ihrer Sekundärseite ein im (ungefährlicheren) Niederspannungsbereich liegendes Messsignal ausgeben, das proportional ist zu der Höhe der jeweils gemessenen Mittelspannung bzw. des Stroms auf Mittelspannungsniveau.

Das Messmodul 25 ist konventionell und dazu ausgeführt, aus Messwerten für Strangspannungen sowie Strangströme jeweils diverse elektrische Parameter zu bestimmen, darunter die Effektivspannung für die drei Stränge, den jeweiligen Phasenwinkel, die in den jeweiligen Strängen fließenden Effektivströme und die jeweiligen Phasenwinkel der Ströme, und weiter darauf basierend Signale auszugeben für die durch die Anschlussleitung 16 fließende Wirkleistung P bzw. Blindleistung Q. Derartige Messmodule sind handelsüblich und brauchen daher bezüglich ihres Aufbaus und ihrer Funktionsweise nicht weiter erläutert zu werden.

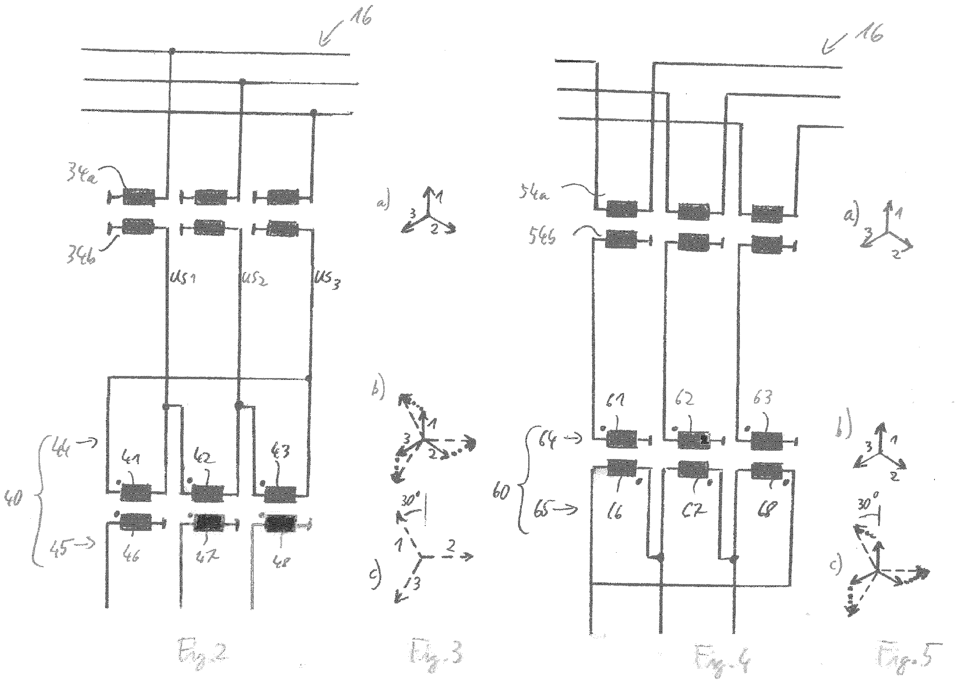

Es wird nun zusätzlich auf Fig. 2-5 Bezug genommen. Um nun mit einem an sich zur Messung von Strangspannung vorgesehenen Messmodul 25 dennoch eine Messung basierend auf verkettete Spannungen zu ermöglichen, ist erfindungsgemäß der Zusatzwandler 40 vorgesehen. Er ist ausgeführt ähnlich einem Messwandler, weist jedoch eine unterschiedliche Verschaltung der Primärseite bezogen auf die Sekundärseite auf. Vorliegend ist auf einer Seite eine Verschaltung als Dreieckschaltung und auf der anderen Seite eine Verschaltung als Sternschaltung vorgesehen. Dazu sind auf einer Primärseite 44 des Zusatzwandlers 40 die einzelnen Spulen 41, 42 und 43 mit identischem Wicklungssinn angeordnet und in Dreieckschaltung zwischen jeweils zwei Strängen geschaltet. Es ergibt sich daraus ein Anstieg der Spannungen bezogen auf die Strangspannung US1, US2 und US3 von $\sqrt{3}$ entsprechend etwa 1,732.

Gleichzeitig kommt es durch die Verschaltung der Primärspulen 41, 42 und 43 zu einer Phasen-Verschwenkung. Deren Betrag ist abhängig von der Art der gewählten Freischaltung und kann 30°, 90°, 150°, 210°, 270° oder 330° betragen. In dem dargestellten Ausführungsbeispiel ist die Verschaltung so gewählt, dass sich eine Verschwenkung um ein Schwenkwinkel von 30° ergibt. Dies ist in den Figuren 3a, b dargestellt. In Figur 3a sind mit durchgezogenen Linien die jeweiligen Strangspannungen phasenrichtig für die drei Stränge 1, 2 und 3 abgebildet. In Figur 3b sind die sich durch die verkettete Verschaltung ergebende Verschwenkung durch gepunktete Linien und die sich ergebende Verstärkung um Faktor $\sqrt{3}$ durch gestrichelte Linien dargestellt.

Auf der Sekundärseite 45 des Zusatzwandlers 40 ist eine Verschaltung in Sternform ausgeführt. Damit ergibt sich keine weitere Verschwenkung. Es ergibt sich somit insgesamt ein Übersetzungsverhältnis von $\sqrt{3}\ /1$ für den Zusatzwandler 40 als Ganzes, bei einer Verschwenkung um 30°. Das sich somit ergebende Ausgangssignal des Zusatzwandlers 40 ist in Figur 3c dargestellt.

Damit verarbeitet das Messmodul nun an sich verkettete Spannungen. Die von dem Messmodul 25 vorgenommene Bestimmung der Phasenwinkel zwischen Spannung und Strom, welche insbesondere für die Berechnung von Wirkleistung und Blindleistung von Bedeutung sind, ist aber durch die von dem Zusatzwandler 40 bewirkte Verschwenkung der Phasen verfälscht. Dies muss ausgeglichen werden, um dennoch korrekte Ergebnisse zu erhalten. Dazu ist der Strom-Zusatzwandler 60 vorgesehen. Dieser ist dazu ausgebildet, die Messsignale für die gemessenen Ströme in den einzelnen Strängen der Anschlussleitung 16 ebenfalls zu verschwenken, und zwar um denselben Schwenkwinkel wie bei dem Zusatzwandler 40 für die Spannungen.

Dazu ist der Strom-Zusatzwandler 60 in der nachfolgend beschriebenen Weise verschaltet. Seine drei auf der Primärseite 64 liegenden Wicklungen 61, 62 und 63 sind in konventioneller Weise sternförmig verschaltet. Das entsprechende Zeigerdiagramm ist in Figur 5a dargestellt. Seine auf der Sekundärseite 65 liegenden Wicklungen 66, 67 und 68 sind gegensinnig angeordnet und ausgangsseitig als Dreieck verschaltet. Die in den Wicklungen 66, 67 und 68 induzierten Ströme sind in dem Zeigerdiagramm in Figur 5b dargestellt. Aus der ausgangsseitigen Verschaltung dieser Wicklungen resultiert eine Verschwenkung der Phasen um 30°, also um genau den Betrag wie durch den Zusatzwandler 40 bei den Spannungen bewirkt. Dies ist im Zeigerdiagramm in Figur 5c dargestellt, wobei ähnlich zu der Darstellung in Figur 3 die Verschwenkung um einen Winkel von 30° angezeigt ist durch eine gepunktete Linie und die durch die dreiecksförmige Verschaltung sich ergebende Verstärkung um einen Faktor von $\sqrt{3}$ durch eine gestrichelte Linie visualisiert ist.

Im Ergebnis liegen die von dem Zusatzwandler 60 ausgegebenen Ströme wieder phasenrichtig zu den von dem Zusatzwandler 40 ausgegebenen Strangspannungen. Somit kann das Messmodul 25, an das diese Werte jeweils angelegt sind, die korrekte relative Phasenlage zwischen Spannungen und Strömen bestimmen, und so wird auch eine korrekte Ermittlung der Wirk- und Blindleistung erreicht.

Somit wird im Ergebnis bei unveränderter Beibehaltung der eigentlichen Messwandler 30, 50 als Messwandler für Strangspannungen dank der Zusatzwandler 40, 60 eine phasenrichtige Umwandlung auf verkettete Größen erreicht. Es kann somit das an sich herkömmliche, für die Verarbeitung von Stranggrößen ausgebildete Messmodul 25 weiterhin verwendet werden, wobei es eben nunmehr dank der Zusatzwandler 40, 60 tatsächlich verkettete Größen verarbeitet.

Zweckmäßigerweise sind die Zusatzwandler 40, 60 in der Art ausgeführt, dass sie eine Übersetzung um einen Faktor von $1/\sqrt{3}$ vornehmen. Auf diese Weise sind die von den Zusatzwandlern 40, 60 ausgegebenen Größen auf denselben Wertebereich normiert wie die eigentlichen Stranggrößen. Am einfachsten geschieht dies dadurch, dass die Wicklungsverhältnisse der Primärspulen 41, 42 und 43 bzw. 61, 62 und 63 zu den jeweiligen Sekundärwicklungen 46, 47 und 48 bzw. 66, 67 und 68 im entsprechenden inversen Verhältnis von $1/\sqrt{3}$ gewählt werden. Dies ermöglicht es, das Messmodul 25 bzw. die Betriebssteuerung 2 mit ihrem Netzschutzmodul 21 unverändert zu lassen.

Alternativ oder zusätzlich können aber auch anstatt einer Übersetzung in den Zusatzwandlern gesonderte Übertrager (nicht dargestellt) vorgesehen sein, die eine entsprechende inverse Übersetzung um den Wert von $1/\sqrt{3}$ vornehmen. Es soll ferner nicht ausgeschlossen sein, eine entsprechende Anpassung der Parametrisierung in den Modulen vorzunehmen; dies bietet sich insbesondere dann an, wenn Zusatzwandler mit passendem Übersetzungsverhältnis nicht verfügbar sind oder die Anpassung der Parametrisierung aus anderen Gründen einfach erfolgen kann.

Mit der dargestellten Anordnung kann unter Berücksichtigung der Auslegung der Zusatzwandler 40, 60 mit einem passenden inversen Übersetzungsverhältnis eine korrekte Berechnung der Wirkleistung auf Mittelspannungsniveau (entlang der Anschlussleitung 16) durchgeführt werden. Dies gilt sowohl für das sog. Mitsystem wie auch für das Gegensystem. Beides wird bei der erfindungsgemäßen Anordnung korrekt übertragen. Anders verhält sich dies in Bezug auf ein Nullsystem; dieses wird bei der erfindungsgemäßen Anordnung in der Regel nicht übertragen. Praktisch ist dies aber ohne Relevanz. Denn zwar kommen Nullsysteme bei der Spannung im Mittelspannungsnetz verhältnismäßig oft vor. Aber in einem typischen Mittelspannungsnetz ohne geerdeten Sternpunkt kann ein Nullsystem des Stroms nicht auftreten. Ist der Strom im Nullsystem aber Null, so bedeutet dies zwingend, dass im Nullsystem keine Wirk- und Blindleistung existiert. Da somit im Mittelspannungsnetz folglich kein Nullsystem für die Wirk- und Blindleistung existiert, spielt dessen fehlende Übertragbarkeit durch die Vorrichtung keine Rolle.

Die erfindungsgemäße Anordnung ermöglicht ferner eine Bestimmung des sogenannten Asymmetrie-Stroms. Hierbei handelt es sich um eine historische Ermittlung von ungleichmäßiger Belastung der Phasen, die einfacher ist als die heute verbreitete Ermittlung von Gegensystem-Strömen. Bezüglich der Ermittlung dieses historischen Asymmetrie-Stroms ist die Erfindung mit ihren Zusatzwandlern ebenso geeignet wie die bisherige Ausführungsform ohne Zusatzwandler.

**Patentansprüche**

1. Windenergieanlage umfassend einen Windrotor (11), einen davon angetriebenen Generator (12) sowie einen Umrichter (13) zur Erzeugung elektrischer Leistung, die über eine mehrphasige Anschlussleitung (16) an ein Netz (19) abgegeben wird, und eine Steuerung (2), die den Betrieb der Windenergieanlage kontrolliert und ein Netzüberwachungsmodul (21) aufweist, wobei Messwandler (30) zur Spannungsmessung vorgesehen sind, die ein Signal für gemessene Strangspannungen (US1, US2, US3) über eine Ausgangsleitung (31, 32, 33) abgeben, **dadurch gekennzeichnet, dass**
den Messwandlern (30) Zusatzwandler (40) nachgeschaltet sind, die in die Ausgangsleitung (31, 32, 33) der Messwandler (30) eingeschleift sind, wobei die Zusatzwandler (40) eine interne Verschaltung aufweisen, welche ausgebildet ist zur Bildung von verketteten Spannungen (US12, US23, US31), und ein Ausgangssignal der Zusatzwandler (40) ein Maß für die verketteten Spannungen (US12, US23, US31) in der Anschlussleitung (16) ist und an die Stelle der Strangspannungen tritt.

2. Windenergieanlage nach Anspruch 1, **dadurch gekennzeichnet, dass** die Zusatzwandler (40) einen Verstärkungsfaktor von kleiner als Eins aufweisen.

3. Windenergieanlage nach Anspruch 2, **dadurch gekennzeichnet, dass** der Verstärkungsfaktor so gewählt ist, dass ein Ausgangspegel der Zusatzwandler (40) übereinstimmt mit einem Ausgangspegel der Messwandler (30).

4. Windenergieanlage nach Anspruch 1 oder 2, **dadurch gekennzeichnet, dass** der Verstärkungsfaktor im Bereich zwischen 1:2 und 2:3 liegt.

5. Windenergieanlage nach einem der Ansprüche 1 bis 4, **dadurch gekennzeichnet, dass** die Zusatzwandler (40) potenzialfrei sind, insbesondere erdfrei.

6. Windenergieanlage nach einem der vorangehenden Ansprüche, **dadurch gekennzeichnet, dass** die Zusatzwandler (40) zur Erfassung der verketteten Spannungen so ausgebildet sind, dass sie eine Verkettung der Spannungen bewirken.

7. Windenergieanlage nach einem der vorangehenden Ansprüche, **dadurch gekennzeichnet, dass** ferner Messwandler (50) für Strom an der mehrphasigen Anschlussleitung vorgesehen sind, denen eine gesonderte Phasenschwenkeinheit nachgeschaltet ist.

8. Windenergieanlage nach Anspruch 7, **dadurch gekennzeichnet, dass** die Phasenschwenkeinheit so ausgebildet ist, dass eine von ihr bewirkte Verschwenkung einem Phasenversatz der Zusatzwandler (40) entspricht.

9. Windenergieanlage nach Anspruch 7 oder 8, **dadurch gekennzeichnet, dass** die Phasenschwenkeinheit als Strom-Zusatzwandler (60) ausgeführt ist, der vorzugsweise einen solchen Verstärkungsfaktor aufweist, der demjenigen der Zusatzwandler (40) für die Spannung entspricht.

10. Windenergieanlage nach einem der vorangehenden Ansprüche, **dadurch gekennzeichnet, dass** die Zusatzwandler (40, 60) Nullsystem-blockend ausgeführt sind.

11. Windenergieanlage nach einem der vorangehenden Ansprüche, **dadurch gekennzeichnet, dass** die Zusatzwandler (40, 60) als zwischenschaltbare, modular einsetzbare Baueinheit ausgeführt sind.

12. Windenergieanlage nach einem der vorangehenden Ansprüche, **dadurch gekennzeichnet, dass** sie einen Anlagentransformator (15) für ein Mittelspannungsniveau aufweist, wobei die Messwandler (30, 50) an einer Netzseite des Anlagentransformators (15) vorgesehen sind.

13. Nachrüstsatz für Windenergieanlagen, umfassend einen Windrotor (11), einen davon angetriebenen Generator (12) sowie einen Umrichter (13) zur Erzeugung elektrischer Leistung, die über eine mehrphasige Anschlussleitung (16) abgegeben wird, und eine Steuerung, die den Betrieb der Windenergieanlage kontrolliert und ein Netzüberwachungsmodul aufweist, wobei Messwandler (30) zur Spannungsmessung vorgesehen sind, die ein Signal für die gemessene Spannung über eine Ausgangsleitung (31, 32, 33) abgeben,
**dadurch gekennzeichnet, dass**
der Nachrüstsatz Zusatzwandler (40) umfasst, die den Messwandlern (30) nachgeschaltet in die Ausgangsleitung der Messwandler eingeschleift sind, wobei die Zusatzwandler (40) eine interne Verschaltung aufweisen, welche ausgebildet ist zur Erfassung von verketteten Spannungen, und das Ausgangssignal der Zusatzwandler ein Maß für die verkettete Spannung in der Anschlussleitung ist.

14. Nachrüstsatz nach Anspruch 13, **dadurch gekennzeichnet, dass** die Zusatzwandler und/oder Strom-Zusatzwandler nach den Ansprüchen 2 bis 11 vorgesehen sind.

15. Verfahren zur Spannungsmessung an einer mehrphasigen Anschlussleitung netzseitig eines Anlagentransformators einer Windenergieanlage, wobei Messwerte für StrangSpannungen in der mehrphasigen Anschlussleitung mittels Messwandlern erfasst und über eine Ausgangsleitung ausgegeben werden,
**gekennzeichnet durch**
Bestimmen der verketteten Spannungen in der mehrphasigen Anschlussleitung aus den Ausgangssignalen der Messwandler mittels nachgeschalteter Zusatzwandler, die intern verschaltet sind zur Erfassung von verketteten Spannungen, und Einschleifen der von den Zusatzwandlern bestimmten Signale in die Ausgangsleitung anstelle der Ausgangssignale der Messwandler.

16. Verfahren nach Anspruch 15, **dadurch gekennzeichnet, dass** Zusatzwandler und/oder Strom-Zusatzwandler nach den Ansprüchen 2 bis 12 vorgesehen sind.

EP 3 462 186 A1

19  16  1  15  14  13  12  11

50

34a  30  36b

31  US1  32  US2  33  US3  IS1  IS2  IS3  54a  54b

40  60

$US_{12}$  $US_{23}$  $US_{31}$  $IS_{12}$  $IS_{23}$  $IS_{31}$

25

$U_{eff}$  $\varphi_u$  $I_{eff}$  $\varphi_I$  P  Q

21

2

Fig. 1

Fig. 2

Fig. 3

Fig. 4

Fig. 5

**Europäisches Patentamt**
**European Patent Office**
**Office européen des brevets**

## EUROPÄISCHER RECHERCHENBERICHT

Nummer der Anmeldung

EP 18 19 6879

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2015 016345 A1 (SENVION GMBH [DE]) 22. Juni 2017 (2017-06-22) * Absätze [0001] - [0004], [0021] - [0022]; Abbildungen 1,5 * ----- | 1-16 | INV. G01R19/00 F03D17/00 |
| X | CH 146 097 A (SIEMENS AG [DE]) 31. März 1931 (1931-03-31) | 13 | |
| Y | * Seite 1, linke Spalte, Absatz 1 - Seite 2, linke Spalte, Absatz 2; Abbildung 1 * ----- | 1-16 | |
| A | US 2017/176536 A1 (GRUBIC STEFAN [US] ET AL) 22. Juni 2017 (2017-06-22) * Absätze [0027] - [0050]; Ansprüche 1-20; Abbildungen 1-5 * ----- | 1-16 | |
| A | DE 102 28 062 A1 (UNIV ULM [DE]) 8. Januar 2004 (2004-01-08) * Absätze [0004] - [0021], [0032] - [0043]; Abbildungen 1-3 * ----- | 1-16 | |

**RECHERCHIERTE SACHGEBIETE (IPC)**

G01R
F03D

Der vorliegende Recherchenbericht wurde für alle Patentansprüche erstellt

| Recherchenort | Abschlußdatum der Recherche | Prüfer |
|---|---|---|
| München | 6. Februar 2019 | Bilzer, Claus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 19 6879

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-02-2019

| Im Recherchenbericht angeführtes Patentdokument | Datum der Veröffentlichung | Mitglied(er) der Patentfamilie | Datum der Veröffentlichung |
|---|---|---|---|
| DE 102015016345 A1 | 22-06-2017 | KEINE | |
| CH 146097 A | 31-03-1931 | KEINE | |
| US 2017176536 A1 | 22-06-2017 | KEINE | |
| DE 10228062 A1 | 08-01-2004 | KEINE | |

EPO FORM P0461

Für nähere Einzelheiten zu diesem Anhang : siehe Amtsblatt des Europäischen Patentamts, Nr.12/82